(19) **Europäisches Patentamt / European Patent Office / Office européen des brevets**

(11) **EP 1 722 360 B1**

(12) **EUROPEAN PATENT SPECIFICATION**

(45) Date of publication and mention
of the grant of the patent:
**19.03.2014 Bulletin 2014/12**

(51) Int Cl.:
*G10L 21/02* ^(2013.01)      *H03H 21/00* ^(2006.01)

(21) Application number: **05010513.9**

(22) Date of filing: **13.05.2005**

(54) **Audio enhancement system and method**

System und Verfahren zur Verbesserung eines Audiosignals

Système et procédé d'amélioration audio

(84) Designated Contracting States:
**AT BE BG CH CY CZ DE DK EE ES FI FR GB GR HU IE IS IT LI LT LU MC NL PL PT RO SE SI SK TR**

(43) Date of publication of application:
**15.11.2006 Bulletin 2006/46**

(73) Proprietor: **Harman Becker Automotive Systems GmbH**
**76307 Karlsbad (DE)**

(72) Inventor: **Christoph, Markus**
**94315 Straubing (DE)**

(74) Representative: **Schmuckermaier, Bernhard**
**Westphal, Mussgnug & Partner**
**Patentanwälte**
**Herzog-Wilhelm-Strasse 26**
**80331 München (DE)**

(56) References cited:
- WEISS S ET AL: "A subband adaptive equalization structure" IEE COLLOQUIUM NOVEL DSP ALGORITHMS AND ARCHITECTURES FOR RADIO SYSTEMS, 28 September 1999 (1999-09-28), pages 4-1, XP006502569
- HARMA A ET AL: "FREQUENCY-WARPED SIGNAL PROCESSING FOR AUDIO APPLICATIONS" JOURNAL OF THE AUDIO ENGINEERING SOCIETY, AUDIO ENGINEERING SOCIETY, NEW YORK, NY, US, vol. 48, no. 11, November 2000 (2000-11), pages 1011-1031, XP001177399 ISSN: 1549-4950
- NEELY S T ET AL: "INVERTIBILITY OF A ROOM IMPULSE RESPONSE" JOURNAL OF THE ACOUSTICAL SOCIETY OF AMERICA, AIP / ACOUSTICAL SOCIETY OF AMERICA, MELVILLE, NY, US, vol. 66, no. 1, July 1979 (1979-07), pages 165-169, XP008021714 ISSN: 0001-4966
- MIYOSHI M ET AL: "INVERSE FILTERING OF ROOM ACOUSTICS" IEEE TRANSACTIONS ON ACOUSTICS, SPEECH AND SIGNAL PROCESSING, IEEE INC. NEW YORK, US, vol. 36, no. 2, 1 February 1988 (1988-02-01), pages 145-152, XP000005739 ISSN: 0096-3518

EP 1 722 360 B1

**Description**

TECHNICAL FIELD

This invention relates to a method for improving the sound reproduced by an audio system in a listening room such as a vehicle interior, and to a system that compensates for linear distortions caused by the audio system and the listening room.

BACKGROUND

Audio signals recorded on CDs, DVDs or other media are generally formatted either during or after the recording in such a way that the desired aural effect is obtained. If the audio signal is replayed through high-quality headphones, the desired aural effect is exactly reproduced for the most part for the listener. In contrast, when listening to a recording in a room, the original aural characteristics are tainted to a greater or lesser degree, depending on the size, shape and layout of the room. This is due, on the one hand, to the transfer function of the room, but on the other hand also to the extent of the reflections that occur. The audio signal is filtered by the transfer function of the total signal chain along the path between the loudspeaker and the listening position in the room, and is corrupted slightly (or 'colored') as a result. A so-called inverse filter can be employed to equalize the coloring caused by the transfer function, which is usually not known. Such equalizing filter must have the inverse characteristic of the unknown transfer function so that the joint circuit comprising the two elements becomes a linear system once again.
Publication Weiss et al: "A subband adaptive equalization structure" in: IEE COLLOQUIUM NOVEL DSP ALGORITHMS AND ARCHITECTURES FOR RADIO SYSTEMS, 28 September 1999, describes a structure for automatic equalization of an unknown transmission channel using subbands single processing.
It is an object of the present invention to create an computationally efficient inverse smoothing filter which can also be referred to as an equalizer.

SUMMARY

The aforementioned object is achieved by the audio enhancement system of claim 1 and the method of claim 11. Accordingly, an audio enhancement system and method is provided for compensating for linear distortions of a sound signal reproduced by an audio system in a listening room; said audio enhancement method comprises analysis filtering for generating a number of analysis output signals from an audio signal to be enhanced; and synthesis filtering for generating an enhanced audio signal from a number of synthesis input signals, wherein said number of analysis output signals and said number of synthesis input signals are identical. Signal processing between the analysis filtering and the synthesis filtering generates one of the synthesis input signals from a respective one of the analysis output signals in order to perform an inverse filtering for equalizing an unknown transfer function established by the audio system and the listening room such that the unknown transfer function complies with a specific target function within the respective frequency range. Each filter bank is a poly-phase Quadrature Mirror Filter (QMF) bank consisting of connected Infinite Impulse Response (IIR) all-pass filters as sub-band filters in a tree structure.

BRIEF DESCRIPTION OF THE DRAWINGS

The invention can be better understood with reference to the following drawings and description. The components in the figures are not necessarily to scale, emphasis instead being placed upon illustrating the principles of the invention. Moreover, in the figures, like reference numerals designate corresponding parts and signals throughout the different views.

FIG 1     is a block diagram of a known system implementing a Filtered X Least Mean Square (FXLMS) algorithm.

FIG 2     is a block diagram of a single-stage poly-phase analysis/synthesis system comprising Infinite Impulse Response (IIR) all-pass filters.

FIG 3     is a signal flow diagram of a 4-stage filter bank with tree structure.

FIG 4     is a diagram showing the magnitude response and phase response of a 16-band, critically sampled sub-band adaptive filter.

FIG 5     is a diagram showing the magnitude response and phase response of a 16-band, critically sampled, inverse sub-band adaptive filter.

FIG 6    is a block diagram of a filter bank in which the lengths of the individual adaptive sub-band filters are adapted to the Bark frequency response exhibit performance.

FIG 7    is a diagram showing the magnitude response and phase response of a target transfer function for automobiles.

FIG 8    is a diagram showing the magnitude response and phase response of a 16-band, critically sampled, inverse sub-band adaptive filter approximating a specified target transfer function.

FIG 9    is a block diagram of an Adaptive Lattice Predictor (ALP) 4th order filter.

FIG 10   is a block diagram of a Lattice all-pole 4th order filter.

FIG 11   is a diagram showing the magnitude response and phase response of a 16-band, critically sampled, inverse sub-band adaptive Gradient Adaptive Lattice (GAL) filter with approximated Bark frequency response.

DETAILED DESCRIPTION

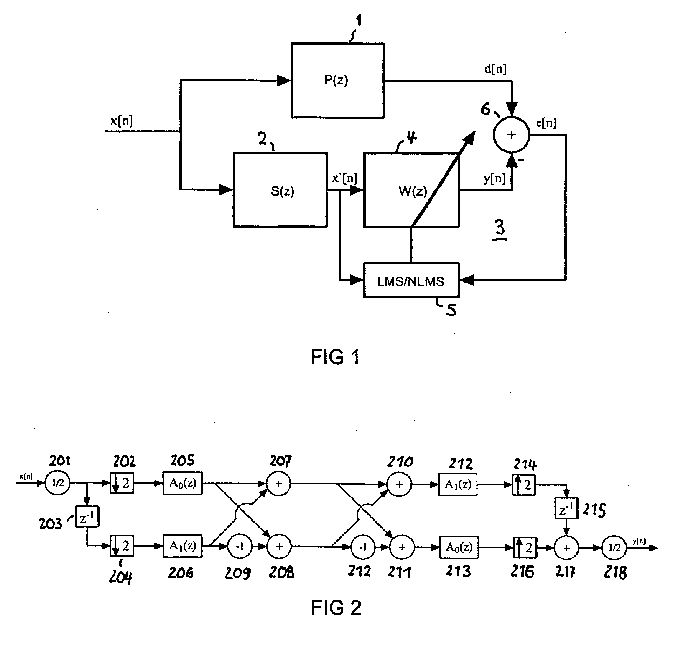

In order to design an inverse filter for linearizing an unknown transfer function, quite a few algorithms can be considered, one of which - the Filtered X (reference or input signal) Least Mean Square (FXLMS) algorithm - is the most well known and most commonly used. The transfer function to be inverted is generally an all-pass filter function (i.e., not a minimum-phase filter) which basically cannot be fully inverted because a non-causal filter would be needed for this purpose. By limiting consideration to the minimum phase component, however, inversion can be achieved fully for the component by compensating all zero positions, which are known in minimum-phase filters to be located within the standardized circuit, with corresponding pole places. Nonetheless, this approach only works approximately if the entire unknown system is to be inverted. An approximation method of this kind is implemented, for example, in a system using the previously cited FXLMS algorithm, as illustrated in FIG 1.

In the system of FIG 1, an input signal x[n] (also referred to as reference signal) is supplied to a partial system 1 having a reference transfer function P(z), and a partial system 2 (e.g., a loudspeaker-room-listener system) having an unknown transfer function S(z). The partial system 2 outputs a filtered input signal x'[n] that is supplied to an adaptive filter comprising a filter core 4 and a Least Mean Square/Normalized Least Mean Square (LMS/NLMS) adaption unit 5 for controlling the filter core 4. The adaption unit 5 receives the filtered input signal x'[n] and an error signal e[n] to generate a control signal for controlling the filter coefficients of the filter core 4. The error signal e[n] is provided by a subtraction unit 6 by subtracting from a filtered reference signal d[n] a signal y[n] from the filter core 4. The adaptive filter forms an inverse filter 3 having a transfer function W(z).

If the inverse filter 3 having the transfer function W(z) is only to equalize the unknown transfer function S(z) the reference transfer function P(z) is not allowed to change the reference or input signal, x[n], but may only delay it. This delay is commonly referred to as the modeling delay and should roughly be about half the length of inverse filter 3. However, if it is desired to not only equalize the unknown transfer function S(z) but also design W(z) so that the series circuit with S(z) complies with a specific function, then P(z) must include this specific function. This situation can be used to full advantage in the design of a target function, particularly if noise signals, such as experienced in cars, have on average the same or a similar power spectral density in that the target function roughly traces the average power spectral density of the noise.

The error signal, e[n], is calculated with reference to FIG. 1 as follows:

$$e[n] = d[n] - y[n]$$
$$= (p^T[n] \cdot x[n]) - (w^T[n] \cdot x'[n])$$
$$= (p^T[n] \cdot x[n]) - (w^T[n] \cdot (s^T[n] \cdot x[n])), \qquad (1)$$

wherein x[n] is the input signal vector at a time n as expressed by

$$x[n] = [x[n] x[n-1] \ldots x[n-L+1]]^T \qquad (2)$$

(L is the filter length of W(z))
and p[n] is the filter coefficient vector of P(z) at a time n as expressed by

$$p[n] = [p_0[n] \ p_1[n] \ \ldots \ p_{L-1}[n]]^T \qquad (3)$$

and s[n] is the filter coefficient vector of S(z) at a time n as expressed by

$$s[n] = [\ s_0[n] \ s_1[n] \ \ldots \ s_{L-1}[n] \ ]^T \qquad (4)$$

and w[n] is the filter coefficient vector of W(z) at a time n as expressed by

$$w[n] = [\ w_0[n] \ w_1[n] \ \ldots \ w_{L-1}[n] \ ]^T. \qquad (5)$$

The filter coefficient update of w[n] is performed iteratively - i.e., at each time n. The filter is designed in such a way that the filter coefficients w[n] are calculated so that the current squared error $e^2[n]$ is minimized. This is normally achieved in practical applications using the LMS (or NLMS) algorithm, which update is referred to as of the coefficient vector w[n] and can be summarized as follows:

$$w[n+1] = w[n] + \mu * x`[n] * e[n], \qquad (6)$$

$$w[n+1] = w[n] + \frac{\mu}{x`[n]^T * x`[n]} * x`[n] * e[n],$$

where $\mu$ is the adaptation step size and x'[n] is the input signal vector previously filtered with S(z) as expressed by

$$x`[n] = [\ x`[n] \ x`[n-1] \ \ldots \ x`[n-L+1] \ ]^T$$

Using an inverse filter designed directly with the FXLMS algorithm - i.e., without any additional modifications usually creates problems. On the one hand, audible artifacts such as pre-echoes may occur, and on the other hand, an inverse filter at times requires very many filter coefficients, which are not readily available in practical applications.

As can be seen easily that this is the case as otherwise equalization is only possible to a base limit frequency, which is set lower and lower the longer the inverse filter is. Unfortunately, the human ear can distinguish between frequencies very well, particularly in the spectral domain, which means that humans react very sensitively to spectral errors. It is therefore important that the inverse filter has a high level of spectral resolution, particularly in the lower spectral domain - signifying, however, that the filter has to be long.

One way of solving this problem, for example, is to use a filter with a non-linear frequency resolution - i.e., one that has high resolution for low frequencies and deteriorating resolution for increasingly higher frequencies. Such filters exist and are referred to as warped, Kautz, or Lagurerre filters, among others. These filters can also be designed as adaptive filters, but they then unfortunately no longer exhibit favorable properties. Consequently, an indirect implementation is preferred - i.e., conversion of a conventional, long adaptive Finite Impulse Response (FIR) filter after its adaptation to a filter with non-linear frequency resolution.

However, with increasing length, adaptive FIR filters suffer more and more from the occurrence of quantization errors, therefore becoming more and more instable or imprecise, meaning that even their direct implementation causes problems in practical cases. A feasible method of implementing very long adaptive FIR filters in practice is, for example, to design the adaptive filter directly in the spectral domain or in sub-bands - in other words, using a multi-rate system.

Each of the two approaches has its own particular advantages and disadvantages. One advantage of calculating in the spectral domain is that the efficient Fast Fourier Transformation (FFT) and Inverse Fast Fourier Transformation (IFFT) algorithms can be used for the transition from the time to the frequency domain and in the other direction, and that adaptive filters adapt very quickly and accurately in the spectral domain. The chief disadvantage of the solution is this enormous amount of computing resources it consumes. In contrast, an implementation using a multi-rate system requires considerably less memory, depending on the design, but is either very inaccurate or needs longer computing times. Both solutions can be very easily scaled, though, and can therefore be flexibly adapted to the resources that are available.

The adaptive filter should - as described earlier - have sufficiently high frequency resolution. For processing in the spectral domain, a correspondingly long FFT has to be used for the transformation from the time to the frequency domain, which necessarily causes a further problem, that of longer signal delays. An implementation in sub-bands according to the invention using a mixture of different signal processing methods can elegantly keep the signal delay to a minimum while at the same time enabling the preferred signal processing method with non-linear frequency resolution to be realized, at least approximately. To do so, the time signal is first split into different frequency bands, which on the one hand reduces the sampling rate, and on the other hand, provides only narrowband time signals. Depending on which spectral domain a narrowband time signal belongs to, it can be processed with a longer or shorter adaptive filter to obtain a differentiated, frequency-dependent spectral resolution. It is advisable to choose the lengths of the corresponding adaptive filters in the sub-bands in such a way that the resulting full frequency resolution approximately matches that of human hearing - i.e., that it roughly follows the Bark frequency scheme.

A very efficient way of implementing a filter bank in memory and computing time terms is to use a critically sampled poly-phase Quadrature Mirror Filter (QMF) bank consisting of connected Infinite Impulse Response (IIR) all-pass filters in a tree structure. A critically sampled, single-stage poly-phase analysis/synthesis system all-pass filters consisting of connected IIR filters is illustrated in FIG 2.

In the filter of FIG 2, an input signal x[n] is divided by 2 in divider unit 201 and then applied to a sample rate down-converter 202 and via a delay unit 203 to a sample rate down-converter 204. The sample rate down-converters 202, 204 are each followed by an IIR all-pass filter 205, 206 having a transfer function Ao(z) or $A_1(z)$, respectively. The output of filter 205 is applied to an adder unit 207 and an adder unit 208. The output of filter 206 is applied to the adder unit 207 and via an inverter 209 to the adder unit 208. Further, the output of adder unit 207 is applied to an adder unit 210 and an adder unit 211. The output of adder unit 208 is applied to the adder unit 210 and via an inverter 212 to the adder unit 211. Filters 212 and 213 are connected downstream to the adder units 210 and 211, respectively, wherein IIR all-pass filter 212 has the transfer function $A_1(z)$ and IIR all-pass filter 213 has the transfer function Ao(z). The output of filter 212 is applied via a sample rate down-converter 214 and a delay unit 215 to an adder unit 217. The output of filter 213 is applied via a sample rate down-converter 216 to the adder unit 217 which provides an output signal y[n] via a divider unit 218 for dividing by 2.

A filter bank with tree structure is obtained by continuous insertion in each case of an analysis/synthesis pair in the signal processing area of the preceding stage.

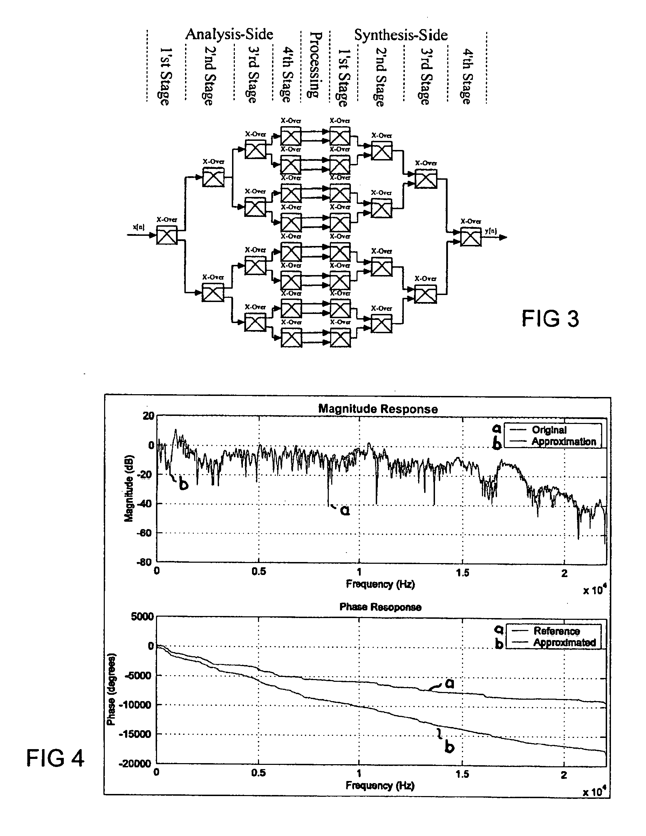

FIG 3 is a signal flow diagram of a 4-stage filter bank with tree structure. Such filter bank comprises 15 analysis filters $Fs_i$ ( i = 1...15) and 15 synthesis filters Fmi (i = 1...15). A first analysis stage comprises one analysis filter splitting an input signal x[n] into two signals for two analysis filters in the second stage. The two analysis filters in the second analysis stage generate, accordingly, four signals for the following third analysis stage which comprises four analysis filters. Finally the fourth stage containing eight analysis filters and receiving eight signals from the third stage generates sixteen output signals which are then further processed by signal processing units (not shown in detail in FIG 3) for providing sixteen input signals for the first synthesis stage having sixteen synthesis filters for providing eight signals for the second synthesis stage. The second synthesis stage comprises four synthesis filters providing four signals to a third synthesis stage having two synthesis filters. Finally a fourth synthesis stage comprising one synthesis filter provides the output signal y[n].

Adaptive filters implemented using a critically sampled multi-rate system basically suffer from the problem that adjacent bands overlap each other and that aliasing occurs as a consequence. Although the aliasing can be reduced by steeper transitions between the limiting bandpass filters, it cannot be fully avoided. An oversampled filter bank may alleviate the situation (cf. Jörg Kliewer, "Beiträge zum Entwurf modulierter Filterbänke für verschiedene Teilbandabtastraten" [On designing modulated filter banks for different sub-band sampling rates], PhD thesis, Sharker Publishers, 1999). Depending on the sampling rate used, the filter bank in some cases needs significantly greater computing resources, which is not regarded as such a big drawback in view of the enormous efficiency of the implementation. Moreover, no implementation of an oversampled filter bank using the uncomplicated, connected IIR all-pass filters is known, meaning that an implementation with FIR filters has to be used, which however increases the memory requirements to a major extent. In the present case, it is for the most part irrelevant whether the IIR filter bank is realized using a multi-complementary, modulated or poly-phase filter bank.

With reference to FIG 4, an example showing the effects of aliasing errors in the approximation of an unknown system using a sub-band adaptive filter with a critically sampled 4-stage poly-phase filter bank with tree structure is discussed. The length of the corresponding adaptive filters in the 16 bands is defined in each case as L=128.

As can be seen from FIG 4, the approximated model only differs notably from the original at the individual band limits. Regarded overall, the errors remain within acceptable limits.

However, it is not important how the aliasing errors behave during the approximation with the original, but rather their inverse behavior. For this reason, the previous example is used again, but this time an adaptive filter is arranged in each sub-band, which is no longer iterated using the NLMS algorithm, but instead the inverse model of the original is approximated using the FXNLMS algorithm.

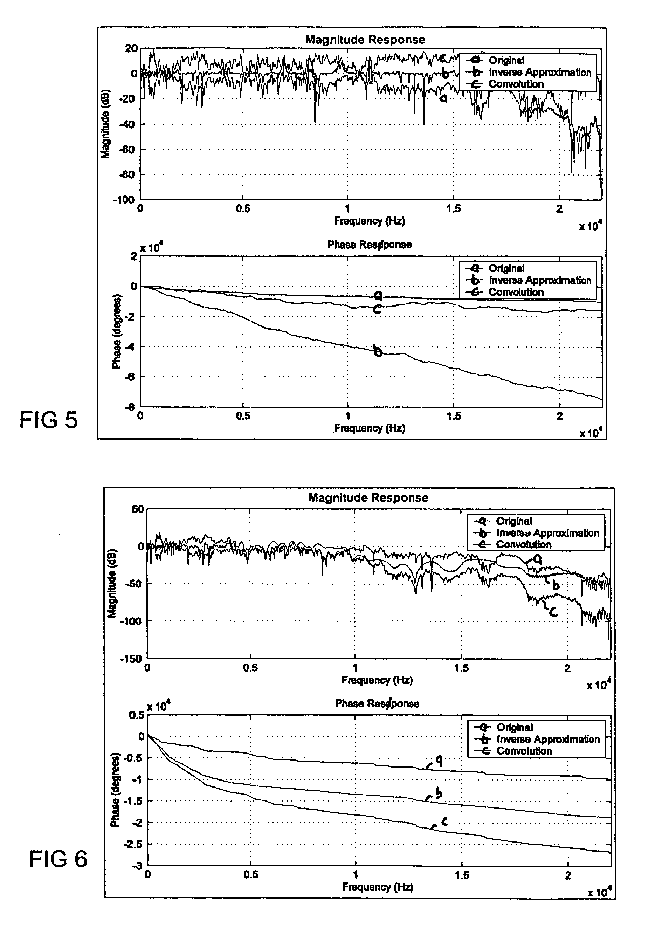

FIG 5 is a diagram illustrating the performance of a 16-band, critically sampled, inverse sub-band adaptive filter. From FIG 5, it can be seen that the band limits of the individual sub-bands can no longer be clearly localized - i.e., during approximation of the inverse original transfer function the aliasing errors appear to be less critical than for the approximation of the original transfer function as shown in FIG 4.

In order to keep the associated errors within limits, an oversampled filter bank is preferred if a filter bank is to be used. The figures shown above are intended to illustrate that considerable savings in resources (computing time as well as memory) can be achieved if certain errors are permitted to be accepted.

In the two previous illustrations, an adaptive filter with the same length was used for each sub-band. The length was selected in such a way that a sufficiently high frequency resolution was obtained in the lower frequency domain. As already explained, this resolution performance is not required for the upper frequency domain owing to the frequency resolution characteristics of the human ear. Consequently, the lengths of the adaptive filters for the upper sub-bands decrease steadily with increasing frequency. A filter bank designed as outlined above in which the lengths of the individual adaptive sub-band filters are adapted to the Bark frequency response exhibit performance corresponding to that shown later in FIG 6.

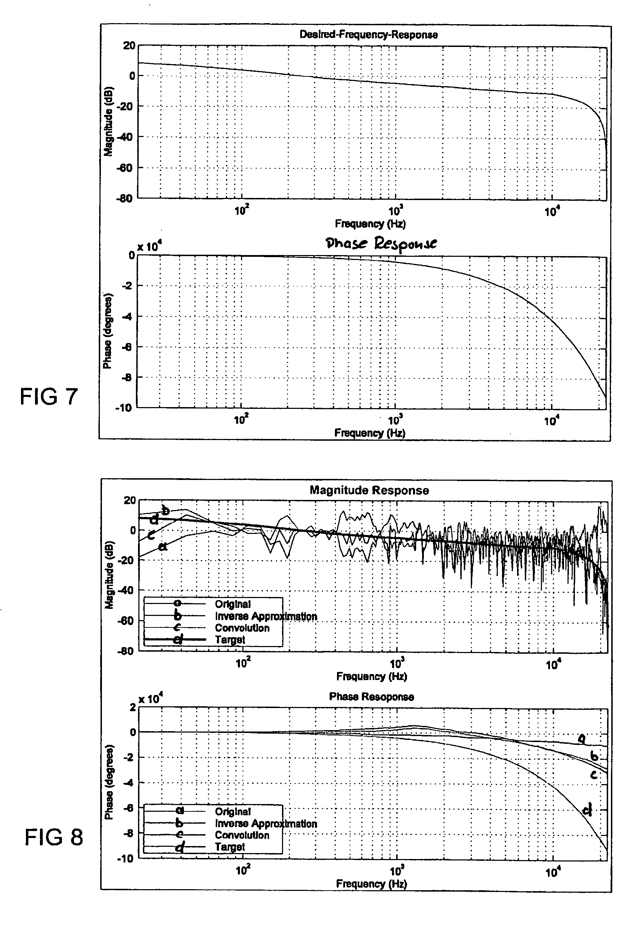

FIG 5 illustrates the performance of a 16-band, critically sampled, inverse sub-band adaptive filter. When determining the inverse filter, a target frequency response can be specified. The adaptation algorithm attempts to produce the inverse filter in such a way that a chain circuit of the same filter with the original transfer function matches the specified target transfer function. What is also known is that the target function should be oriented approximately with the mean power spectral density of the noise signal. Low-frequency noise signals dominate in automobiles, implying that a target transfer function such as shown in FIG 7 below can be specified.

Due to the logarithmic representation of Figure 7, it is not immediately evident that the phases of the target transfer function are linear. Other than that, one can see that the function falls continuously with increasing frequency, which mainly also corresponds to the typical impulse response of the interior of an automobile. Maintaining the target function at a constant value from a specific base limit frequency on would indubitably cause an enormous rise in the upper frequency domain. By selecting the target transfer function shown above the rise in the function remains generally moderate, even in the upper frequency domain. This is illustrated in the example of FIG 8 which shows the performance of a 16-band, critically sampled, inverse sub-band adaptive filter approximating a specified target transfer function. As can be seen from FIG 8, the convolution of the original impulse response with that of the approximated inverse filter mainly closely matches the specified target transfer function without the need for strong increases in the upper frequency domain.

A minimum phase transfer function can be easily inverted fully in a direct way. However, the all-pass splitting (which is needed to isolate the minimum phase component in a maximum phase system) is difficult to be accomplished, at least not in real time. The minimum phase component of the transfer function alone can be iteratively determined directly using the Linear Predictive Coding (LPC) coefficients. An efficient method of calculating the LPC coefficients is provided by the Gradient Adaptive Lattice (GAL) algorithm. Using this algorithm, any number of LPC coefficients can be iteratively computed without the need of the complex Levinson-Durbin recursion.

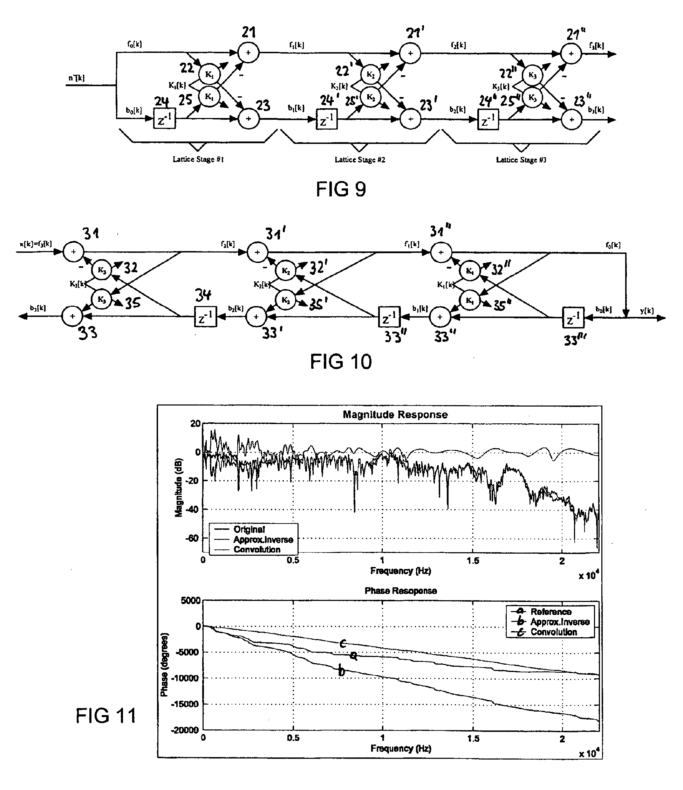

The filter structure with which the GAL algorithm can be realized may be an Adaptive Lattice Predictor (ALP) structure. An example for an Adaptive Lattice Predictor (ALP) $4^{th}$ order filter is shown in FIG 9, in which the signal n~[k] to be filtered is split into a signal $f_0[k]$ and a signal $b_0[k]$. Signal $f_0[k]$ is applied to a subtraction unit 21 and to a multiplier unit 22 where it is multiplied by a constant factor $K_1$. The signal output of multiplier unit 22 is applied to a subtraction unit 23 which further receives a signal from a delay unit 24 for delaying the signal $b_0[k]$. The delayed signal $b_0[k]$ is also supplied to a multiplier unit 25 where it is multiplied by the constant factor $K_1$. The signal output of multiplier unit 25 is applied to subtraction unit 21 which outputs a signal $f_1[k]$ while subtraction unit 23 outputs a signal $b_1[k]$. Subtraction units 21, 23, multipliers 22, 25, and delay unit 24 form a first Lattice stage which is followed by two further Lattice stages. Accordingly, signals $f_1[k]$, $b_1[k]$ are applied to the second stage outputting signals $f_2[k]$, $b_2[k]$, which are applied to the third stage outputting signals $f_3[k]$, $b_3[k]$ as output signals of the ALP $4^{th}$ order filter. The second and third Lattice stage comprise subtraction units 21', 23', multipliers 22', 25', delay unit 24' or subtraction units 21'', 23'', multipliers 22'', 25'', delay unit 24'', respectively, wherein all three stages have the same circuit structure.

The ALP filter reproduces the minimum phase part of the unknown transfer function. The LPC coefficients of the ALP filter ($K_1$, ..., $K_{N-1}$) are calculated iteratively using the GAL algorithm.

$$K_n[k+1] = K_n[k] + \frac{\alpha}{P_n[k]} * \left(f_{n-1}[k] * b_n[k] + b_{n-1}[k-1] * f_n[k]\right)$$

with $\qquad\qquad\qquad\qquad\qquad\qquad\qquad\qquad\qquad\qquad (9)$

$$P_n[k] = (1-\alpha) * P_n[k-1] + \alpha * \left(f_{n-1}[k]^2 + b_{n-1}[k-1]^2\right), n = 1,...,N-1$$

To invert the minimum phase component of the unknown transfer function, the LPC coefficients calculated using the GAL algorithm can be directly inserted, for example, in a Lattice all-pole filter. Such Lattice all-pole 4th order filter is illustrated in FIG 10. In the filter shown in FIG. 10, in which signal $f_3[k]$ forms an input signal $x[k]$ that is applied to a subtraction unit 31, wherein subtraction unit 31 also receives a signal from a delay unit 34 via a multiplier unit 32 multiplying it by a constant factor $K_3$. Subtraction unit 31 outputs the signal $f_2[k]$ which is also applied via a multiplier unit 35 for multiplying it by factor $K_3$ to a subtraction unit 33 which further receives the signal $b_2[k]$ delayed by delay unit 34. Subtraction units 31, 33, multipliers 32, 35, and delay unit 34 form a first Lattice stage which is followed by two further Lattice stages. The second and third Lattice stage comprise subtraction units 31', 33', multipliers 32', 35', delay unit 34' or subtraction units 31'', 33'', multipliers 32'', 35'', delay unit 34'', respectively, wherein all three stages have the same circuit structure. Accordingly, signals $f_3[k]$, $b_2[k]$ are applied to the first stage outputting signals $f_2[k]$ and $b_3[k]$. Signals $f_2[k]$ and $b_1[k]$ are applied to the second stage outputting signals $f_1[k]$ and $b_2[k]$. Signals $f_1[k]$ and $b_0[k]$ are applied to the third stage outputting signals $f_0[k]$ and $b_1[k]$. Signal $f_0[k]$ serves as signal $b_0[k]$ and as output signal $y[k]$ of the Lattice all-pole 4th order filter.

However, the direct use of the LPC coefficients is only advisable under specific conditions, namely provided sufficient computing time is available depending on the Digital Signal Processor (DSP) used. Lattice filters may require considerably greater computing power on one hand, but on the other hand it may be used as a low-noise, dynamic filter structure, due to their symmetrical structure, lattice filters produce only minimal quantization noise. Otherwise, the use of a simple IIR-only filter - e.g., in direct form - is the preferred method since it is generally much easier to implement and more efficient in its application. However, to use a simple IIR filter, the LPC (reflection) filter coefficients must first be converted to their appropriate direct form. They can then be further transformed if required into warped filter coefficients, for example.

Direct, broadband use of the GAL algorithm is possible, but requires a lot of computing time and, similar to the adaptive FIR filter, also suffers from quantization problems if long lengths are used. The direct use of a warped GAL algorithm also experienced the same weaknesses as the direct use of the adaptive warped FIR filter.

A very efficient application of the GAL algorithm is to embed it in a multi-rate signal processing system. Then, for example, the inverse of the minimum phase component of the unknown transfer function could be directly determined in each sub-band, and converted using the Lattice all-pole filter shown previously. A direct implementation in this case would only moderately extend the computing time since - for a multi-rate system - the complex filters are operated in the undersampled domain. The performance of a 16-band, critically sampled, inverse sub-band adaptive GAL filter with approximated Bark frequency response is shown in FIG 11.

Although various exemplary embodiments of the invention have been disclosed, it will be apparent to those skilled in the art that various changes and modifications can be made which will achieve some of the advantages of the invention without departing from the scope of the invention as defined by the appended claims. It will be obvious to those reasonably skilled in the art that other components performing the same functions may be suitably substituted. Further, the methods of the invention may be achieved in either all software implementations, using the appropriate processor instructions, or in hybrid implementations that utilize a combination of hardware logic and software logic to achieve the same results.

## Claims

1. Audio enhancement system for compensating for linear distortions of a sound signal (x[n]) reproduced by an audio system in a listening room; said audio enhancement system comprising:

an analysis filter bank having a plurality of analysis sub-filters (205, 206) and receiving an audio signal to be enhanced and generating a number of analysis output signals corresponding to different frequency ranges of the input signal;

a synthesis filter bank having a plurality of synthesis sub-filters (212, 213) and generating an enhanced audio signal from a number of synthesis input signals; wherein said number of analysis output signals and said number of synthesis input signals are identical and at least two; and

a processing unit connected between the analysis filter bank and the synthesis filter bank and comprising a number of adaptive sub-band filters; wherein each of said adaptive sub-band filters receives one of the analysis output signals, and each generates one of the synthesis input signals; the adaptive sub-band filters forming an inverse filter for equalizing an unknown transfer function established by the audio system and the listening room such that the unknown transfer function complies with a specific target function (P(z)) within the respective frequency range,

**characterized in that** each filter bank is a poly-phase Quadrature Mirror Filter (QMF) bank consisting of connected Infinite Impulse Response (IIR) all-pass filters as sub-band filters in a tree structure.

2. The audio enhancement system of claim 1 wherein at least one adaptive sub-band filter involves a Least Mean Square algorithm.

3. The audio enhancement system of claim 2 wherein the at least one adaptive sub-band filter comprises

a first partial system receiving an analysis output signal as an reference signal and having a reference transfer function, and

a second partial system established by the audio system and the listening room having an unknown transfer function, wherein

the second partial system outputs a filtered reference signal that is supplied to an adaptive Least Mean Square filter, said adaptive Least Mean Square filter receives the filtered reference signal and an error signal to control its filter coefficients; said error signal being provided by subtracting from the filtered reference signal a signal output by the adaptive Least Mean Square filter.

4. The audio enhancement system of one of claims 1 to 3 wherein the filter banks have a non-linear frequency resolution.

5. The audio enhancement system of claim 4 wherein the lengths of the individual adaptive sub-band filters are adapted to said non-linear frequency resolution.

6. The audio enhancement system of claim 4 or 5 wherein the non-linear frequency resolution is adapted to the Bark scale.

7. The audio enhancement system of one of claims 1 to 6 wherein the analysis filter bank comprises multiple analysis sub-filters arranged in a tree structure; each one of said analysis sub-band filters splitting one input signal into at least two output signals.

8. The audio enhancement system of one of claims 1 to 7 wherein the synthesis filter bank comprises multiple synthesis sub-band filters arranged in a tree structure; each one of said synthesis sub-band filters combining at least two input signals into one output signal.

9. The audio enhancement system of one of claims 1 to 8 wherein the analysis and synthesis sub-band filters are operated at a critical sample rate.

10. The audio enhancement system of one of claims 1 to 8 wherein the analysis and synthesis sub-band filters are operated at an over-sampling sample rate.

11. Audio enhancement method for compensating for linear distortions of a sound signal (x[n]) reproduced by an audio system in a listening room; said audio enhancement method comprising:

an analysis filtering step for generating in sub-bands corresponding to different frequency ranges a number of analysis output signals from an audio signal to be enhanced;

a synthesis filtering step for generating an enhanced audio signal from a number of synthesis input signals; wherein said number of analysis output signals and said number of synthesis input signals are identical and at least two; and

a processing step between the analysis filtering step and the synthesis filtering step for generating one of the synthesis input signals from a respective one of the analysis output signals in order to perform an inverse filtering for equalizing an unknown transfer function established by the audio system and the listening room such that the unknown transfer function complies with a specific target function (P(z)) within the respective frequency range,

**characterized in that** each filtering step comprises a poly-phase Quadrature Mirror Filtering (QMF) using connected Infinite Impulse Response (IIR) all-pass filters as sub-band filters in a tree structure.

12. The audio enhancement method of claim 11 wherein the processing step involves a Least Mean Square algorithm.

13. The audio enhancement method of claim 12 wherein the processing step comprises

a first partial filtering step including receiving an analysis output signal as an reference signal and processing the reference signal with a reference transfer function, and

a second partial filtering step performed by the audio system and the listening room with an unknown transfer function, wherein

the second partial filtering step outputs a filtered reference signal that is supplied to an adaptive Least Mean Square filtering step,

said adaptive Least Mean Square filtering step receives the filtered reference signal and an error signal to control its filtering; said error signal being provided by subtracting from the filtered reference signal a signal output by the adaptive Least Mean Square filter.

14. The audio enhancement method of one of claims 11 to 13 wherein the filtering steps have a non-linear frequency resolution.

15. The audio enhancement method of claim 14 wherein the lengths of the individual adaptive filtering steps are adapted to said non-linear frequency resolution.

16. The audio enhancement method of claim 14 or 15 wherein the non-linear frequency resolution is adapted to the Bark scale.

17. The audio enhancement method of one of claims 11 to 16 wherein the filtering steps comprise multiple sub-band filtering steps performed in according to a tree structure; each one of said sub-band filtering steps splitting one input signal into at least two output signals.

18. The audio enhancement method of one of claims 14 to 17 wherein the filtering steps are performed at a critical sample rate.

19. The audio enhancement method of one of claims 14 to 18 wherein the filtering steps are performed at an over-sampling sample rate.

**Patentansprüche**

1. Audioverstärkungssystem zum Kompensieren linearer Verzerrungen eines akustischen Signals (x[n]), das von einem Audiosystem in einem Hörraum wiedergegeben wird; wobei das Audioverstärkungssystem Folgendes umfasst:

- eine Analyse-Filterbank, die eine Vielzahl von Analyse-Nebenfiltern (205, 206) aufweist und ein zu verstärkendes Audiosignal empfängt und eine Anzahl von Analyse-Ausgangssignalen generiert, die verschiedenen Frequenzbereichen des Eingangssignals entsprechen;
- eine Synthese-Filterbank, die eine Vielzahl von Synthese-Nebenfiltern (212, 213) aufweist und ein verstärktes Audiosignal aus einer Anzahl von Synthese-Eingangssignalen generiert; wobei die Anzahl von Analyse-Ausgangssignalen und die Anzahl von Synthese-Eingangssignalen identisch und mindestens gleich zwei ist; und
- eine Verarbeitungseinheit, die zwischen der Analyse-Filterbank und der Synthese-Filterbank angeschlossen ist und eine Anzahl von adaptiven Teilbandfiltern umfasst; wobei jedes der adaptiven Teilbandfilter eines der Analyse-Ausgangssignale empfängt und jedes eines der Synthese-Eingangssignale generiert; wobei die adaptiven Teilbandfilter ein Umkehrfilter zum Entzerren einer unbekannten Übertragungsfunktion bilden, die von dem Audiosystem und dem Hörraum aufgestellt wird, so dass die unbekannte Übertragungsfunktion mit einer spezifischen Zielfunktion (P(z)) in dem jeweiligen Frequenzbereich übereinstimmt,

9

- **dadurch gekennzeichnet, dass** jede Filterbank eine mehrphasige Quadraturspiegelfilter- (QMF) Bank ist, die aus verbundenen Allpassfiltern mit unendlicher Impulsantwort (IIR) als Teilbandfilter in einer Baumstruktur besteht.

2. Audioverstärkungssystem nach Anspruch 1, wobei mindestens ein adaptives Teilbandfilter einen LMS- ("Least Mean Squares") Algorithmus umfasst.

3. Audioverstärkungssystem nach Anspruch 2, wobei das mindestens eine adaptive Teilbandfilter Folgendes umfasst:

   - ein erstes Teilsystem, das ein Analyse-Ausgangssignal als Referenzsignal empfängt und eine Referenzübertragungsfunktion aufweist, und
   - ein zweites Teilsystem, das von dem Audiosystem und dem Hörraum aufgestellt wird und eine unbekannte Übertragungsfunktion aufweist, wobei
   - das zweite Teilsystem ein gefiltertes Referenzsignal ausgibt, das einem adaptiven LMS-Filter zugeführt wird,
   - das adaptive LMS-Filter das gefilterte Referenzsignal und ein Fehlersignal empfängt, um seine Filterkoeffizienten zu steuern; wobei das Fehlersignal dadurch bereitgestellt wird, dass von dem gefilterten Referenzsignal ein Signal abgezogen wird, das von dem adaptiven LMS-Filter ausgegeben wird.

4. Audioverstärkungssystem nach einem der Ansprüche 1 bis 3, wobei die Filterbänke eine nicht lineare Frequenzauflösung aufweisen.

5. Audioverstärkungssystem nach Anspruch 4, wobei die Längen der einzelnen adaptiven Teilbandfilter an die nicht lineare Frequenzauflösung angepasst sind.

6. Audioverstärkungssystem nach Anspruch 4 oder 5, wobei die nicht lineare Frequenzauflösung an die Bark-Skala angepasst ist.

7. Audioverstärkungssystem nach einem der Ansprüche 1 bis 6, wobei die Analyse-Filterbank mehrere Analyse-Teilfilter umfasst, die in einer Baumstruktur angeordnet sind; wobei jedes der Analyse-Teilbandfilter ein Eingangssignal in mindestens zwei Ausgangssignale aufteilt.

8. Audioverstärkungssystem nach einem der Ansprüche 1 bis 7, wobei die Synthese-Filterbank mehrere Synthese-Teilbandfilter umfasst, die in einer Baumstruktur angeordnet sind; wobei jedes der Synthese-Teilbandfilter mindestens zwei Eingangssignale zu einem Ausgangssignal kombiniert.

9. Audioverstärkungssystem nach einem der Ansprüche 1 bis 8, wobei die Analyse- und Synthese-Teilbandfilter auf einer kritischen Abtastfrequenz betätigt werden.

10. Audioverstärkungssystem nach einem der Ansprüche 1 bis 8, wobei die Analyse- und Synthese-Teilbandfilter auf einer Überabtastfrequenz betätigt werden.

11. Audioverstärkungsverfahren zum Kompensieren linearer Verzerrungen eines akustischen Signals (x[n]), das von einem Audiosystem in einem Hörraum wiedergegeben wird; wobei das Audioverstärkungsverfahren Folgendes umfasst:

   - einen Analyse-Filterschritt, um in Teilbändern, die verschiedenen Frequenzbereichen entsprechen, eine Anzahl von Analyse-Ausgangssignalen aus einem zu verstärkenden Audiosignal zu generieren;
   - einen Synthese-Filterschritt zum Generieren eines verstärkten Audiosignals aus einer Anzahl von Synthese-Eingangssignalen; wobei die Anzahl von Analyse-Ausgangssignalen und die Anzahl von Synthese-Eingangssignalen identisch und mindestens gleich zwei ist; und
   - einen Verarbeitungsschritt zwischen dem Analyse-Filterschritt und dem Synthese-Filterschritt zum Generieren eines der Synthese-Eingangssignale aus einem jeweiligen der Analyse-Ausgangssignale, um eine Umkehrfilterung auszuführen, um eine unbekannte Übertragungsfunktion zu entzerren, die von dem Audiosystem und dem Hörraum aufgestellt wird, so dass die unbekannte Übertragungsfunktion mit einer spezifischen Zielfunktion (P(z)) in dem jeweiligen Frequenzbereich übereinstimmt,
   - **dadurch gekennzeichnet, dass** jeder Filterschritt ein mehrphasiges Quadraturspiegelfiltern (QMF) unter Verwendung von verbundenen Allpassfiltern mit unendlicher Impulsantwort (IIR) als Teilbandfilter in einer Baumstruktur umfasst.

**12.** Audioverstärkungsverfahren nach Anspruch 11, wobei der Verarbeitungsschritt einen LMS-Algorithmus einbezieht.

**13.** Audioverstärkungsverfahren nach Anspruch 12, wobei der Verarbeitungsschritt Folgendes umfasst:

- einen ersten Teilfilterschritt, der das Empfangen eines Analyse-Ausgangssignals als Referenzsignal und das Verarbeiten des Referenzsignals mit einer Referenzübertragungsfunktion umfasst, und
- einen zweiten Teilfilterschritt, der von dem Audiosystem und dem Hörraum mit einer unbekannten Übertragungsfunktion ausgeführt wird, wobei
- der zweite Teilfilterschritt ein gefiltertes Referenzsignal ausgibt, das einem adaptiven LMS-Filterschritt zugeführt wird,
- der adaptive LMS-Filterschritt das gefilterte Referenzsignal und ein Fehlersignal empfängt, um seine Filterung zu steuern; wobei das Fehlersignal dadurch bereitgestellt wird, dass von dem gefilterten Referenzsignal ein Signal abgezogen wird, das von dem adaptiven LMS-Filter ausgegeben wird.

**14.** Audioverstärkungsverfahren nach einem von Anspruch 11 bis 13, wobei die Filterschritte eine nicht lineare Frequenzauflösung aufweisen.

**15.** Audioverstärkungsverfahren nach Anspruch 14, wobei die Längen der einzelnen adaptiven Filterschritte an die nicht lineare Frequenzauflösung angepasst sind.

**16.** Audioverstärkungsverfahren nach Anspruch 14 oder 15, wobei die nicht lineare Frequenzauflösung an die Bark-Skala angepasst ist.

**17.** Audioverstärkungsverfahren nach einem der Ansprüche 11 bis 16, wobei die Filterschritte mehrere Teilbandfilterschritte umfassen, die gemäß einer Baustruktur ausgeführt werden; wobei jeder der Teilbandfilterschritte ein Eingangssignal in mindestens zwei Ausgangssignale aufteilt.

**18.** Audioverstärkungsverfahren nach einem der Ansprüche 14 bis 17, wobei die Filterschritte auf einer kritischen Abtastfrequenz ausgeführt werden.

**19.** Audioverstärkungsverfahren nach einem der Ansprüche 14 bis 18, wobei die Filterschritte auf einer Überabtastfrequenz ausgeführt werden.

**Revendications**

**1.** Système d'amélioration audio pour compenser les distorsions linéaires d'un signal sonore (x[n]) reproduit par un système audio dans une pièce d'écoute ; ledit système d'amélioration audio comprend :

une banque de filtre d'analyse ayant une pluralité de sous-filtres d'analyse (205, 206) et recevant un signal audio pour être amélioré et générer un nombre de signaux de sortie d'analyse correspondant aux différents intervalles de fréquence du signal d'entrée ;
une banque de filtre de synthèse ayant une pluralité de sous-filtres de synthèse (212, 213) et générant un signal audio amélioré d'un nombre de signaux d'entrée de synthèse ; dans lequel ledit nombre de signaux de sortie d'analyse et ledit nombre de signaux d'entrée de synthèse sont identiques et au moins deux ; et
une unité de traitement connectée entre la banque de filtre d'analyse et la banque de filtre de synthèse et comprenant un nombre de filtres de sous-bande adaptatifs ; dans lequel chacun des lesdits filtres de sous-bande adaptatifs reçoivent un des signaux de sortie d'analyse, et chacun génère un des signaux d'entrée de synthèse ; les filtres de sous-bande adaptatifs formant un filtre inverse pour égaliser une fonction de transfert inconnue établie par le système audio et la chambre d'écoute tel que la fonction de transfert inconnue soit conforme avec une fonction cible spécifique (P(z)) dans un intervalle de fréquence respective, **caractérisé en ce que** chaque banque de filtre est une banque de filtre miroir en quadrature (QMF) polyphasique consistant en des filtres passe-tout à réponse impulsionnelle infinie (IIR) connectés comme des filtres de sous-bande dans une structure en arborescence.

**2.** Système d'amélioration audio de la revendication 1, dans lequel au moins un filtre de sous-bande adaptatif implique un algorithme des moindres carrés moyens.

3. Système d'amélioration audio de la revendication 2, dans lequel le au moins un filtre de sous-bande adaptatif comprend
un premier système partiel recevant un signal de sortie d'analyse comme un signal de référence et ayant une fonction de transfert de référence, et
un second système partiel établi par le système audio et la chambre d'écoute ayant une fonction de transfert inconnue, dans lequel
le second système partiel génère un signal de référence filtré qui est fourni à un filtre adaptatif des moindres carrés moyens,
ledit filtre adaptatif des moindres carrés moyens reçoit le signal de référence filtré et un signal d'erreur pour contrôler ses coefficients de filtre ; ledit signal d'erreur étant fourni par soustraction du signal de référence filtré une sortie de signal par le filtre adaptatif des moindres carrés moyens.

4. Système d'amélioration audio de l'une des revendications 1-3, dans lequel les banques de filtre ont une résolution de fréquence non-linéaire.

5. Système d'amélioration audio de la revendication 4, dans lequel les longueurs des filtres de sous bande adaptatifs individuels sont adaptées pour ladite résolution de fréquence non-linéaire.

6. Système d'amélioration audio de la revendication 4 ou 5, dans lequel la résolution de fréquence non-linéaire est adaptée à l'échelle de Bark.

7. Système d'amélioration audio de l'une des revendications 1-6, dans lequel la banque de filtre d'analyse comprend de multiples sous-filtres d'analyse arrangés en une structure en arborescence ; chacun desdits filtres de sous-bande d'analyse divisant un signal d'entrée en au moins deux signaux de sortie.

8. Système d'amélioration audio de l'une des revendications 1-7, dans lequel la banque de filtre de synthèse comprend de multiples filtres de sous-bande de synthèse arrangés en une structure en arborescence ; chacun desdits filtres de sous-bande de synthèse combinant au moins deux signaux d'entrée en un signal de sortie.

9. Système d'amélioration audio de l'une des revendications 1-8, dans lequel les filtres de sous-bande de synthèse et d'analyse sont exploités à un taux échantillonnage critique.

10. Système d'amélioration audio de l'une des revendications 1-8, dans lequel les filtres de sous-bande de synthèse et d'analyse sont exploités à un taux d'échantillonnage de sur-échantillonnage.

11. Procédé d'amélioration audio pour compenser les distorsions linéaires d'un signal sonore (x[n]) reproduit par un système audio dans une pièce d'écoute ; ledit procédé d'amélioration audio comprend :

une étape de filtrage d'analyse pour générer dans des sous-bandes correspondant aux intervalles de fréquence différents un nombre de signaux de sortie d'analyse depuis un signal audio devant être amélioré ;
une étape de filtrage de synthèse pour générer un signal audio amélioré d'un nombre de signaux d'entrée de synthèse ; dans lequel ledit nombre de signaux de sortie d'analyse et ledit nombre de signaux d'entrée de synthèse sont identiques et au moins deux ; et
une étape de traitement entre l'étape de filtrage d'analyse et l'étape de filtrage de synthèse pour générer un des signaux d'entrée de synthèse d'un des signaux respectifs de sortie d'analyse afin d'effectuer un filtrage inverse pour égaliser une fonction de transfert inconnue établie par le système audio et la chambre d'écoute tel que la fonction de transfert inconnue soit conforme avec une fonction cible spécifique (P(z)) dans un intervalle de fréquence respectif,
**caractérisé en ce que** chaque étape de filtrage comprend un filtrage miroir en quadrature polyphasique (QMF) en utilisant des filtres passe-tout à réponse impulsionnelle infinie (IIR) connectés comme filtres de sous-bande dans une structure en arborescence.

12. Procédé d'amélioration audio de la revendication 11, dans lequel l'étape de traitement implique un algorithme des moindres carrés moyens.

13. Procédé d'amélioration audio de la revendication 12, dans lequel l'étape de traitement comprend
une première étape de filtrage partiel incluant la réception d'un signal de sortie d'analyse comme un signal de référence et le traitement d'un signal de référence avec une fonction de transfert de référence, et

une seconde étape de filtrage partiel effectuée par le système audio et la chambre d'écoute avec une fonction de transfert inconnue, dans lequel

la seconde étape de filtrage partiel génère un signal de référence filtré qui est fourni à une étape adaptative de filtrage des moindres carrés moyens.

ladite étape adaptative de filtrage des moindres carrés moyens reçoit le signal de référence filtré et un signal d'erreur pour contrôler son filtrage ; ledit signal d'erreur étant fourni par soustraction du signal de référence filtré une sortie de signal par le filtre adaptatif des moindres carrés moyens.

**14.** Procédé d'amélioration audio de l'une des revendications 11 à 13, dans lequel les étapes de filtrage ont une résolution de fréquence non-linéaire.

**15.** Procédé d'amélioration audio de la revendication 14, dans lequel les longueurs des étapes de filtrage adaptatives individuelles sont adaptées pour ladite résolution de fréquence non-linéaire.

**16.** Procédé d'amélioration audio de la revendication 14 à 15, dans lequel la résolution de fréquence non-linéaire est adaptée à l'échelle de Bark.

**17.** Procédé d'amélioration audio de l'une des revendications 11-16, dans lequel les étapes de filtrage comprennent de multiples étapes de filtrage de sous-bande effectuées selon une structure en arborescence ; chacune desdites étapes de filtrage de sous-bande divisant un signal d'entrée en au moins deux signaux de sortie.

**18.** Procédé d'amélioration audio de l'une des revendications 14 à 17, dans lequel les étapes de filtrage sont effectuées à un taux d'échantillonnage critique.

**19.** Procédé d'amélioration audio de l'une des revendications 14 à 18, dans lequel les étapes de filtrage sont effectuées à un taux d'échantillonnage de sur-échantillonnage.

FIG 1

FIG 2

FIG 3

FIG 4

FIG 5

FIG 6

FIG 7

FIG 8

**FIG 9**

**FIG 10**

**FIG 11**

# EP 1 722 360 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WEISS et al.** A subband adaptive equalization structure. *IEE COLLOQUIUM NOVEL DSP ALGORITHMS AND ARCHITECTURES FOR RADIO SYSTEMS,* 28 September 1999

- Beiträge zum Entwurf modulierter Filterbänke für verschiedene Teilbandabtastraten. **JÖRG KLIEWER.** PhD thesis. Sharker Publishers, 1999